# EUROPÄISCHE PATENTSCHRIFT

(11) **EP 0 682 467 B1**
(45) Veröffentlichungstag und Bekanntmachung des Hinweises auf die Patenterteilung: **30.06.1999**
(21) Anmeldenummer: 95106524.2
(22) Anmeldetag: 29.04.1995
(51) Int. Cl.: H05K 5/00, H05K 7/20

(54) **Schaltungsanordnung zur Gebläsesteuerung für Kraftfahrzeuge**
Circuit device for controlling a blower in a vehicle
Circuit pour commande d'un ventilateur d'automobile

(30) Priorität: 10.05.1994 DE 4416460
(43) Veröffentlichungstag der Anmeldung: 15.11.1995
(73) Patentinhaber: Hella KG Hueck & Co., 59552 Lippstadt (DE)
(72) Erfinder: Hagen, Andreas, D-59590 Geseke (DE); Katzwinkel, Reiner, D-38527 Meine (DE); Degenhardt, Wolfgang, D-38524 Sassenburg (DE)

(56) Entgegenhaltungen:
- WO-A-92/22090
- DE-A- 3 416 348
- DE-A- 4 118 398
- DE-A- 4 222 838

## Beschreibung

Die Erfindung betrifft eine Schaltungsanordnung, insbesondere zur Gebläsesteuerung für Kraftfahrzeuge, mit einem Kühlkörper, mit einem wärmeerzeugenden elektrischen Bauelement, das auf dem Kühlkörper befestigt ist, mit elektrischen Anschlußelementen und mit einem Gehäuseteil, das das Bauelement gegen Umgebungseinflüsse schützt.

Derartige Schaltungsanordnungen sind bekannt und dienen z. B. der Ansteuerung insbesondere von Lüftungsgebläsen in Heiz- oder Klimaanlagen von Kraftfahrzeugen. Dabei erhält die Schaltungsanordnung über die elektrischen Anschlußelemente neben der Versorgungsspannung ein Steuersignal von einer elektrischen oder elektronischen Heizungs- oder Klimaregelungseinheit, die z. B. abhängig von der gemessenen Raumtemperatur eine Gebläsedrehzahl des zugehörigen Gebläsemotors vorgibt. Als wärmeerzeugendes elektrisches Bauelement ist dabei üblicherweise ein oder mehrere Leistungstransistoren vorgesehen, die bei der durchgeführten Spannungssteuerung der Versorgungsspannung des Gebläsemotors Verlustwärme erzeugen.

Eine derartige Schaltungsanordnung ist aus der DE 25 54 747 A1 vorbekannt. Dort ist zum Abführen der Verlustwärme das wärmeerzeugende elektrische Bauelement unmittelbar auf einen Kühlkörper aufgelötet. Der Kühlkörper soll dabei aufgrund seiner Wärmekapazität und seiner verglichen mit den Bauelementen großen wärmeabstrahlenden Fläche für eine genügende Wärmeabfuhr der von dem elektrischen Bauelement erzeugten Verlustwärme sorgen.

Diese vorbekannte Schaltungsanordnung, bei der die wärmeerzeugenden elektrischen Bauelemente direkt auf dem Kühlkörper befestigt sind, weist jedoch Nachteile auf. So ist der Leistungsbedarf z. B. der verwendeten Gebläsemotoren häufig so groß, daß zur Vermeidung einer überhitzung der wärmeerzeugenden elektrischen Bauelemente mehrere derartige Bauelemente verwendet werden müssen. Diese überhitzung der wärmeerzeugenden elektrischen Bauelemente kommt im wesentlichen dadurch zustande, daß die Kontaktfläche des Bauelementes auf dem Kühlkörper nur eine geringe Größe aufweist, und insofern die erforderliche Wärmeabfuhr vom wärmeerzeugenden Bauelement zum Kühlkörper nur unvollständig erfolgen kann.

Die verwendeten Leistungstransistoren als wärmeerzeugende Bauelemente sind jedoch verglichen mit dem Gesamtwert der Schaltungsanordnung sehr teuer, so daß beispielsweise die Verwendung zweier derartiger Bauelemente statt eines Bauelementes den Gesamtpreis der Schaltungsanordnung stark erhöht. Ein Verzicht auf eines oder mehrere dieser Bauelemente führt jedoch zu einer thermischen überlastung dieser Bauelemente.

Aus der DE 39 35 272 C2 ist es bekannt, ein Bauelement durch Schrauben an einem Kühlblech zu befestigen.

Die Erfindung hat die Aufgabe, eine Schaltungsanordnung zur Gebläsesteuerung für Kraftfahrzeuge zu schaffen, bei der die Wärmeabfuhr von dem wärmeerzeugenden Bauelement zum Kühlkörper soweit verbessert ist, daß die Zahl der erforderlichen Bauelemente gegenüber dem Vorbekannten reduziert werden kann.

Diese Aufgabe wird erfindungsgemäß dadurch gelöst, daß zwischen dem Bauelement und dem Kühlkörper ein Metallblech angeordnet ist, dessen Fläche größer ist als die Grundfläche des Bauelements und kleiner ist als die Grundfläche des Kühlkörpers und daß das Bauelement mit dem Metallblech verlötet ist.

Durch die erfindungsgemäß vorgesehene Lötverbindung zwischen dem wärmeerzeugenden Bauelement und dem Metallblech ist eine sehr gute thermische Kopplung zwischen diesen beiden Bauteilen gewährleistet. Die während des Lötvorgangs thermische Belastung des Bauelementes, insbesondere bei Verwendung eines Leistungstransistors, führt nicht zu dessen Zerstörung, wie Versuche gezeigt haben.

Durch die Verwendung eines Metallbleches, dessen Fläche wesentlich größer ist als die Grundfläche des Bauelementes, ist die thermische Kopplung zwischen dem Metallblech und dem Kühlkörper gegenüber dem Vorbekannten wesentlich verbessert, so daß insgesamt die Wärmeabfuhr von dem wärmeerzeugenden elektrischen Bauelement zu dem Kühlkörper gegenüber dem Vorbekannten soweit verbessert ist, daß in einem konkreten Fall statt zweier wärmeerzeugender Bauelemente ein derartiges Bauelement verwendet werden konnte.

Die erfindungsgemäße Lösung kann fertigungstechnisch einfach umgesetzt werden, da nach dem Verlöten des Metallbleches mit dem Bauelement, beispielsweise in einem Schwallbad, die Baueinheit bestehend aus diesen beiden Bauteilen wie ein einziges wärmeerzeugendes Bauelement im weiteren Fertigungsprozeß gehandhabt werden kann.

Weiterhin ist als einziges zusätzliches Teil bei Anwendung der Erfindung das genannte Metallblech erforderlich. Dafür fällt jedoch in vielen Fällen eines oder mehrere der vorher erforderlichen Bauelemente weg, so daß sich durch Anwendung der Erfindung gegenüber dem Vorbekannten ein erheblicher Kostenvorteil erzielen läßt.

Vorteilhafte Ausgestaltungen und Weiterbildungen der erfindungsgemäßen Schaltungsanordnung gehen aus den Unteransprüchen hervor.

Als Metallblech kann vorteilhaft ein Kupferblech verwendet werden, weil Kupfer eine sehr gute Wärmeleitfähigkeit aufweist und andererseits auf einfache Art und Weise gelötet werden kann. Bei Anwendung der Erfindung kommt es im wesentlichen auf die Verwendung von Metallblechen mit guter Wärmeleitfähigkeit an. Die Wärmekapazität der verwendeten Materialien spielt hingegen nur eine untergeordnete Rolle, da das Metallblech nicht den Kühlkörper ersetzen soll, sondern allein den Wärmeübergang vom wärmeerzeugenden Bauteil auf den Kühlkörper verbessern soll.

Versuche haben gezeigt, daß die erfindungsgemäß gewünschte Verbesserung des Wärmeüberganges bereits dann erzielt werden kann, wenn die Fläche des Metallbleches etwa dreimal so groß ist wie die Grundfläche des Bauelementes, weil damit auch die Kontaktfläche zwischen dem Metallblech und dem Kühlkörper gegenüber der vorbekannten Lösung um den Faktor 3 vergrößert ist.

Um eine weitere Verbesserung des Wärmeüberganges vom Metallblech auf den Kühlkörper zu erzielen, ist es besonders vorteilhaft, wenn zwischen dem Metallblech und dem Kühlkörper Wärmeleitpaste angeordnet ist.

Die Befestigung der Baueinheit, bestehend aus dem wärmeerzeugenden elektrischen Bauelement und dem Metallblech, auf dem Kühlkörper erfolgt vorteilhaft durch einen Klemmbügel, der durch Nieten mit dem Kühlkörper verbunden ist.

Insbesondere dann, wenn neben dem wärmeerzeugenden elektrischen Element noch weitere Bauteile, wie z. B. elektrische Widerstände, in der Schaltungsanordnung angeordnet werden sollen, ist es vorteilhaft, wenn die elektrischen Anschlüsse des Bauelements und die elektrischen Anschlußelemente durch Lötverbindungen mit einer elektrischen Leiterplatte verbunden sind, die die weiteren elektrischen Bauteile trägt. In diesem Zusammenhang kann die Ebene der Leiterplatte senkrecht zur Ebene des Metallblechs angeordnet sein, wobei das Metallblech Fortsätze aufweist, die Öffnungen der Leiterplatte durchdringen. Hiermit kann eine schüttelsichere mechanische Verbindung der Leiterplatte mit dem Metallblech hergestellt werden, die auch den hohen Anforderungen an Schaltungsanordnungen für die Verwendung in Kraftfahrzeugen genügt.

Die Fortsätze können dabei vorteilhaft Spreizarme zur Befestigung in den Öffnungen der Leiterplatte aufweisen. Diese Spreizarme werden nach Durchstecken der Fortsätze in die Öffnungen der Leiterplatte aufgespreizt, so daß zusätzlich zu einer gegebenenfalls erfolgenden Schwallbadverlötung auch eine direkte mechanische Verbindung der Leiterplatte mit dem Metallblech gegeben ist.

Eine fertigungstechnisch einfache Verbindung des Gehäuseteils mit dem Kühlkörper stellt die Verwendung von Rastmitteln dar, so daß zur Endfertigung der erfindungsgemäßen Schaltungsanordnung allein das Gehäuseteil auf den Kühlkörper aufgeschnappt wird.

Die Dicke des Metallblechs ist vorteilhafterweise geringer als die Dicke des Bauelementes und die Dicke des Kühlkörpers. Dies ist deshalb sinnvoll, weil es bei der Verwendung des Metallbleches nicht auf eine große Masse des Metallbleches im Hinblick auf eine große Wärmekapazität, sondern auf eine gute Wärmeleitfähigkeit des Metallbleches vom wärmeerzeugenden Bauelement zum Kühlkörper ankommt.

Ein Ausführungsbeispiel der erfindungsgemäßen Schaltungsanordnung ist in den Zeichnungen dargestellt und wird im folgenden anhand der Zeichnungen näher erläutert.

Es zeigen
Figur 1 eine erfindungsgemäße Schaltungsanordnung in einer Seitenansicht, teilweise geschnitten,
Figur 2 die Schaltungsanordnung gemäß Figur 1 in einer Stirnseitenansicht, teilweise geschnitten,
Figur 3 eine Baueinheit der Schaltungsanordnung gemäß Figur 1 und
Figur 4 die Baueinheit mit Leiterplatte und elektrischen Anschlußelementen der Schaltungsanordnung gemäß Figur 1.

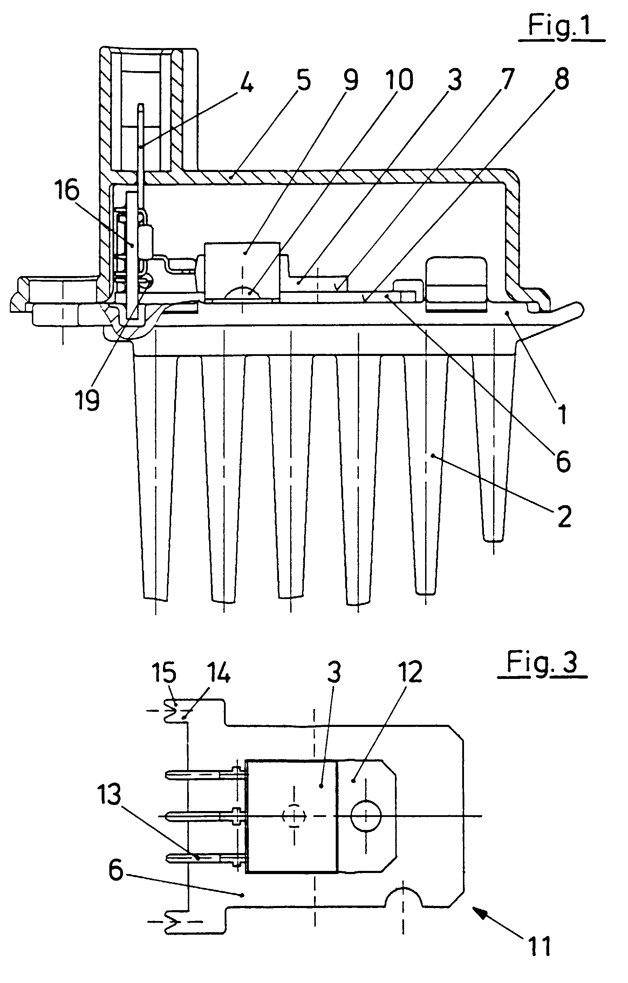

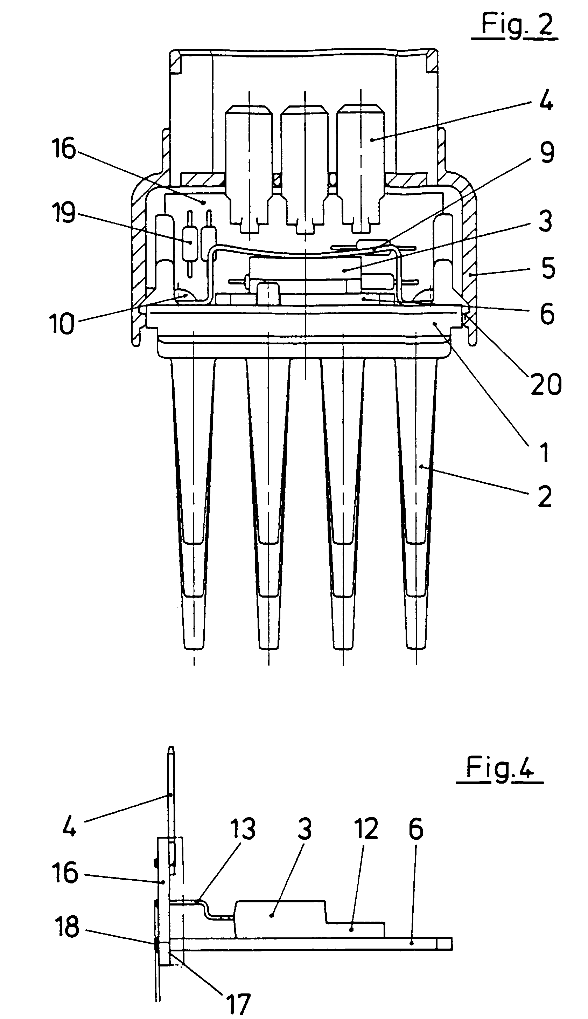

In der Figur 1 weist die Schaltungsanordnung zur Gebläsesteuerung für Kraftfahrzeuge einen Kühlkörper (1) auf, der als Fingerkühlkörper ausgebildet ist. Die Kühlkörperfinger (2) dieses Fingerkühlkörpers ragen dabei üblicherweise in einen Luftströmungskanal der Heizungs- oder Klimaanlage des Kraftfahrzeuges, wobei der übrige Teil des Kühlkörpers (1) einen Teil der Wandung dieses Luftströmungskanals bildet, der in den Figuren nicht dargestellt ist. Die Schaltungsanordnung weint weiterhin ein wärmeerzeugendes elektrisches Bauelement (3) auf, das über eine Leiterplatte (16) und teilweise über elektrische Bauteile (19) mit elektrischen Anschlußelementen (4) elektrisch leitend verbunden ist.

Weiterhin weist die Schaltungsanordnung ein Gehäuseteil (5) auf, das das Bauelement (3) gegen Umgebungseinflüsse schützt und außerhalb des Luftströmungskanals angeordnet ist, so daß die elektrischen Anschlußelemente (4) mittels eines Steckers einfach von außerhalb des Luftströmungskanals zugänglich sind.

Zwischen dem wärmeerzeugenden elektrischen Bauelement (3) und dem Kühlkörper (1) ist ein Metallblech (6) angeordnet, das im vorliegenden Ausführungsbeispiel aus Kupfer besteht. Dabei ist das Bauelement (3) auf dem Metallblech (6) mittels einer Lötverbindung (7) befestigt. Die Wärmeleitung zwischen dem Metallblech (6) und dem Kühlkörper (1) wird durch eine Wärmeleitpaste (8) verbessert, die zwischen den Kontaktflächen dieser beiden Teile angeordnet ist.

Die Baueinheit, bestehend aus dem Bauelement (3) und dem Metallblech (6), ist mittels eines Klemmbügels (9) auf der Fläche des Kühlkörpers (1) befestigt, wobei der Klemmbügel (9) mittels Nieten (10) am Kühlkörper (1) befestigt ist.

In der Figur 2 sind gleiche oder gleichwirkende Teile der Schaltungsanordnung wie in der Figur 1 mit denselben Bezugszeichen versehen. In der Figur 2 erkennt man zusätzlich die Rastverbindungen (20) zwischen dem Kühlkörper (1) und dem Gehäuseteil (5), die eine einfache Verbindung dieser beiden Teile ermöglichen.

In der Figur 3 ist die Baueinheit (11), bestehend aus dem wärmeerzeugenden elektrischen Bauelement (3) und dem daran angelöteten Metallblech (6), dargestellt. Man erkennt, daß das Bauelement (3) metallblechseitig eine Kühl- und Befestigungslasche (12) aufweist, die wie das Metallblech aus metallischem Werkstoff besteht, und insofern einfach mit dem Metallblech verlötet werden kann.

Weiterhin sind in der Figur 3 die elektrischen Anschlüsse (13) des Bauelementes (3) dargestellt und es ist erkennbar, daß das Kupferblech (6) Fortsätze (14) aufweist, die in dieselbe Richtung weisen wie die elektrischen Anschlüsse (13) des Bauelementes (3) und die an ihrem Ende Spreizarme (15) aufweisen.

In der Figur 4 sind gleiche oder gleichwirkende Einrichtungsteile wie in der Figur 3 mit denselben Bezugszeichen versehen. Man erkennt in der Figur 4, daß die Fortsätze (14) des Kupferbleches (6) durch Öffnungen (17) der Leiterplatte (16) hindurchgesteckt sind, und nach dem Hindurchstecken die Spreizarme (15) derart aufgespreizt sind, daß eine mechanische Verbindung zwischen der Leiterplatte (16) und dem Metallblech (6) hergestellt wird. Nach dem Herstellen dieser mechanischen Verbindung und dem Einstecken der elektrischen Anschlußelemente (4) und der elektrischen Anschlüsse (13) des Bauelementes (3) wird die gesamte in der Figur 4 dargestellte Anordnung, beispielsweise im Schwallbad verlötet, wie dies in der Figur durch die Lötverbindungen (18) dargestellt ist.

Anschließend kann die gesamte Anordnung gemäß Figur 4 mittels Klemmbügel (9) an dem Kühlkörper (1) befestigt werden.

## Patentansprüche

1. Schaltungsanordnung, insbesondere zur Gebläsesteuerung für Kraftfahrzeuge, mit einem Kühlkörper (1), mit einem wärmeerzeugenden elektrischen Bauelement (3), das auf dem Kühlkörper (1) befestigt ist, mit elektrischen Anschlußelementen (4) und mit einem Gehäuseteil (5), das das Bauelement (3) gegen Umgebungseinflüsse schützt, dadurch gekennzeichnet, daß zwischen dem Bauelement (3) und dem Kühlkörper (1) ein Metallblech (6) angeordnet ist, dessen Fläche größer ist als die Grundfläche des Bauelements (3) und kleiner ist als die Grundfläche des Kühlkörpers (1) und daß das Bauelement (3) mit dem Metallblech (6) verlötet ist.

2. Schaltungsanordnung nach Anspruch 1, dadurch gekennzeichnet, daß das Metallblech (6) ein Kupferblech ist.

3. Schaltungsanordnung nach Anspruch 1, dadurch gekennzeichnet, daß die Fläche des Metallbleches (6) etwa dreimal so groß ist wie die Grundfläche des Bauelements (3).

4. Schaltungsanordnung nach Anspruch 1, dadurch gekennzeichnet, daß zwischen dem Metallblech (6) und dem Kühlkörper (1) Wärmeleitpaste (8) angeordnet ist.

5. Schaltungsanordnung nach Anspruch 1, dadurch gekennzeichnet, daß die Baueinheit (11), bestehend aus Bauelement (3) und Metallblech (6), durch einen Klemmbügel (9) auf dem Kühlkörper (1) befestigt ist, wobei der Klemmbügel (9) durch Nieten (10) mit dem Kühlkörper (1) verbunden ist.

6. Schaltungsanordnung nach Anspruch 1, dadurch gekennzeichnet, daß die elektrischen Anschlüsse (13) des Bauelements (3) und die elektrischen Anschlußelemente (4) durch Lötverbindungen (18) mit einer elektrischen Leiterplatte (16) verbunden sind, die weitere elektrische Bauteile (19) trägt.

7. Schaltungsanordnung nach Anspruch 6, dadurch gekennzeichnet, daß die Ebene der Leiterplatte (16) senkrecht zur Ebene des Metallbleches (6) angeordnet ist und daß das Metallblech (6) Fortsätze (14) aufweist, die Öffnungen (17) der Leiterplatte (16) durchdringen.

8. Schaltungsanordnung nach Anspruch 7, dadurch gekennzeichnet, daß die Fortsätze (14) Spreizarme (15) zur Befestigung in den Öffnungen (17) der Leiterplatte (16) aufweisen.

9. Schaltungsanordnung nach Anspruch 1, dadurch gekennzeichnet, daß das Gehäuseteil (5) mit dem Kühlkörper (1) verrastet ist.

10. Schaltungsanordnung nach Anspruch 1, dadurch gekennzeichnet, daß die Dicke des Metallbleches (6) geringer ist als die Dicke des Bauelements (3) und die Dicke des Kühlkörpers (1).

## Claims

1. Circuit device, especially for controlling a blower in motor vehicles, having a heat sink (1), having a heat generating electrical component (3) which is secured on the heat sink (1), having electrical contact elements (4), and having a housing part (5) which protects the component (3) from surrounding influences, characterised in that between the component (3) and the heat sink (1) a metal plate (6) is arranged whose surface area is greater than the base surface of the component (3) and smaller than the base surface of the heat sink (1) and in that the component (3) and the metal plate (6) are soldered together.

2. Circuit device according to claim 1, characterised in that the metal plate (6) is a copper plate.

3. Circuit device according to claim 1, characterised in that the surface area of the metal plate (6) is about three times larger than the base surface of the component (3).

4. Circuit device according to claim 1, characterised in that heat conducting compound (8) is arranged between the metal plate (6) and the heat sink (1).

5. Circuit device according to claim 1, characterised in that the unit (11), consisting of the component (3) and the metal plate (6), is secured tc the heat sink (1) by a clamping strap (9), the clamping strap (9) being connected to the heat sink (1) by rivets (10).

6. Circuit device according to claim 1, characterised in that the electrical contacts (13) of the component (3) and the electrical contact elements (4) are connected by way of soldered connections (18) to an electrical circuit board (16) which carries further electrical parts (19).

7. Circuit device according to claim 6, characterised in that the plane of the circuit board (16) is arranged perpendicularly with respect to the plane of the metal plate (6) and in that the metal plate (6) has extensions (14) which pass through apertures (17) of the circuit board (16).

8. Circuit device according to claim 7, characterised in that the extensions (14) have expanding arms (15) for securing in the apertures (17) of the circuit board (16).

9. Circuit device according to claim 1, characterised in that the housing part (5) is latched with the heat sink (1).

10. Circuit device according to claim 1, characterised in that the thickness of the metal plate (6) is less than the thickness of the component (3) and less than the thickness of the heat sink (1).

## Revendications

1. Circuit, en particulier pour la commande d'un ventilateur pour véhicules, comportant un corps de refroidissement (1), un composant électrique (3) thermogène qui est fixé sur le corps de refroidissement (1), des éléments de raccordement électrique (4) et une partie de boîtier (5) qui protège le composant (3) vis-à-vis de l'environnement, caractérisé en ce qu'entre le composant (3) et le corps de refroidissement (1) est agencée une tôle métallique (6) dont la surface est supérieure à la surface de base du composant (3) et inférieure à la surface de base du corps de refroidissement (1) et en ce que le composant (3) est soudé à la tôle métallique (6).

2. Circuit selon la revendication 1, caractérisé en ce que la tôle métallique (6) est une tôle en cuivre.

3. Circuit selon la revendication 1, caractérisé en ce que la surface de la tôle métallique (6) est approximativement trois fois plus grande que la surface de base du composant (3).

4. Circuit selon la revendication 1, caractérisé en ce qu'une pâte thermoconductrice (8) est agencée entre la tôle métallique (6) et le corps de refroidissement (1).

5. Circuit selon la revendication 1, caractérisé en ce que l'ensemble (11) constitué par le composant (3) et la tôle métallique (6) est fixé sur le corps de refroidissement (1) par un étrier de serrage (9), l'étrier de serrage (9) étant relié par des rivets (10) au corps de refroidissement (1).

6. Circuit selon la revendication 1, caractérisé en ce que les bornes électriques (13) du composant (3) et les éléments de raccordement électrique (4) sont reliés par soudage (18) à une carte à circuit imprimé (16) électrique qui porte d'autres composants (19) électriques.

7. Circuit selon la revendication 6, caractérisé en ce que le plan de la carte à circuit imprimé (16) est agencé perpendiculaire au plan de la tôle métallique (6) et en ce que la tôle métallique (6) présente des prolongements (14) qui traversent des ouvertures (17) de la carte à circuit imprimé (16).

8. Circuit selon la revendication 7, caractérisé en ce que les prolongements (14) présentent des bras d'écartement (15) destinés à la fixation dans les ouvertures (17) de la carte à circuit imprimé (16).

9. Circuit selon la revendication 1, caractérisé en ce que la partie de boîtier (5) est enclenchée avec le corps de refroidissement (1).

10. Circuit selon la revendication 1, caractérisé en ce que l'épaisseur de la tôle métallique (6) est inférieure à l'épaisseur du composant (3) et à l'épaisseur du corps de refroidissement (1).
